# FASCICULE DE BREVET EUROPEEN

(11) **EP 3 483 889 B1**
(45) Date de publication et mention de la délivrance du brevet: **16.06.2021**
(21) Numéro de dépôt: 18202683.1
(22) Date de dépôt: 25.10.2018
(51) Int. Cl.: G11C 13/00, H01L 45/00, H01L 27/24

(54) **PUCE À MÉMOIRE NON VOLATILE EMBARQUÉE À MATÉRIAU À CHANGEMENT DE PHASE**
NICHT-FLÜCHTIGER EINGEBAUTER SPEICHERCHIP AUS EINEM MATERIAL MIT PHASENÄNDERUNG
NON-VOLATILE MEMORY CHIP BUILT INTO PHASE-CHANGE MATERIAL

(30) Priorité: 09.11.2017 FR 1760543
(43) Date de publication de la demande: 15.05.2019
(73) Titulaire: STMicroelectronics (Grenoble 2) SAS, 38000 Grenoble (FR); STMicroelectronics (Crolles 2) SAS, 38920 Crolles (FR); STMICROELECTRONICS (ROUSSET) SAS, 13790 Rousset (FR)
(72) Inventeur: ARNAUD, Franck, 38330 SAINT NAZAIRE LES EYMES (FR); GALPIN, David, 38570 LE CHEYLAS (FR); ZOLL, Stéphane, 38190 FROGES (FR); HINSINGER, Olivier, 38530 BARRAUX (FR); FAVENNEC, Laurent, 38190 VILLARD BONNOT (FR); ODDOU, Jean-Pierre, 38330 SAINT ISMIER (FR); BROUSSOUS, Lucile, 38570 GONCELIN (FR); BOIVIN, Philippe, 13770 VENELLES (FR); WEBER, Olivier, 38000 GRENOBLE (FR); BRUN, Philippe, 38240 MEYLAN (FR); MORIN, Pierre, 3010 KESSEL-LO (BE)
(74) Mandataire: Cabinet Beaumont

(56) Documents cités:
- US-A1- 2003 185 047
- US-A1- 2005 111 247
- US-A1- 2015 028 283
- US-A1- 2019 326 510

## Description

### Domaine

La présente demande concerne les puces électroniques, et en particulier une puce contenant une mémoire non volatile à matériau à changement de phase, et un procédé de fabrication d'une telle puce.

### Exposé de l'art antérieur

Une puce à mémoire non volatile embarquée à matériau à changement de phase comprend simultanément des circuits logiques et des points mémoire à matériau à changement de phase. Les points mémoire et les divers transistors des circuits sont reliés électriquement par des vias à des pistes d'interconnexion situées dans des couches électriquement isolantes.

Chaque point mémoire comprend un matériau à changement de phase et un élément résistif de chauffage du matériau à changement de phase. L'élément résistif de chauffage permet de faire passer le matériau à changement de phase d'un état cristallin à l'état amorphe pour la programmation du point mémoire, et d'un état amorphe à l'état cristallin pour l'effacement du point mémoire. L'élément de chauffage est typiquement situé sous le matériau à changement de phase et sur un via de liaison à l'une des bornes de l'un des transistors de la mémoire.

Les puces à mémoire non volatile embarquée à matériau à changement de phase obtenues par des procédés connus présentent divers inconvénients. En particulier, on souhaite réduire la résistance électrique d'accès aux transistors due notamment à la résistance électrique des vias. Les documents US 2019/326510 A1 et US 2003/185047 A1 décrivent des cellules de mémoire à changement de phase, dans lesquelles l'élément de chauffage est intégré au niveau d'une première couche métallique. Les documents US 2005/111247 A1 et US 2015/028283 A décrivent des cellules de mémoire à changement de phase, dans lesquelles l'élément de chauffage est intégré à l'aide des espaceurs.

### Résumé

Un mode de réalisation prévoit de pallier tout ou partie des inconvénients ci-dessus.

Ainsi, un mode de réalisation prévoit un procédé de fabrication d'une puce électronique comportant des points mémoire à matériau à changement de phase, comprenant : a) former un premier niveau de métal comprenant des premières pistes d'interconnexion ; et b) pour chaque point mémoire, former un élément de chauffage du matériau à changement de phase contre des flancs de portions de la première couche.

Selon un mode de réalisation, le procédé comprend : avant l'étape a), former des transistors et des premiers et deuxièmes vias s'étendant depuis des bornes des transistors et atteignant une même hauteur, les premières pistes formées à l'étape a) étant en contact avec les premiers vias, et les éléments de chauffage formés à l'étape b) étant sur les deuxièmes vias ; et c) former le matériau à changement de phase de chaque point mémoire sur l'élément de chauffage.

Selon un mode de réalisation, le procédé comprend :former un deuxième niveau de métal comprenant des deuxièmes pistes d'interconnexion et situé au-dessus des matériaux à changement de phase ; et former des troisièmes vias s'étendant des matériaux à changement de phase jusqu'aux deuxièmes pistes d'interconnexion.

Selon un mode de réalisation, le procédé, comprend entre les étapes b) et c), le dépôt d'une couche de protection, de préférence en nitrure de silicium, sur les premières pistes d'interconnexion.

Selon un mode de réalisation, le procédé comprend, à l'étape a) : graver des tranchées traversant la première couche ; et remplir les tranchées par un matériau électriquement conducteur jusqu'à un niveau supérieur de la première couche.

Selon un mode de réalisation, le procédé comprend, avant l'étape b), la formation de premiers espaceurs contre lesdits flancs en formant une couche en un matériau des premiers espaceurs et en retirant ensuite par gravure anisotrope les portions horizontales de la couche en matériau des premiers espaceurs, la première couche étant en un isolant thermique.

Selon un mode de réalisation, le procédé comprend, à l'étape a) : c2) graver des portions de la première couche jusqu'au niveau des sommets des deuxièmes vias, lesdits flancs étant les flancs des portions restantes de la première couche, en faisant en sorte que le sommet de chaque deuxième via soit partiellement recouvert d'un des premiers espaceurs et partiellement exposé ; et, à l'étape b) : b1) former une deuxième couche conforme en le matériau du futur élément de chauffage ; b2) former un deuxième espaceur recouvrant la portion de la deuxième couche située contre chaque premier espaceur, puis retirer les parties exposées de la deuxième couche ; b3) former un troisième espaceur contre chaque deuxième espaceur ; b4) graver partiellement la structure jusqu'au niveau des sommets de deuxièmes vias de manière à individualiser les éléments de chauffage constitués chacun d'une portion de la deuxième couche ; et b5) recouvrir la structure d'une troisième couche de protection.

Selon un mode de réalisation, le procédé comprend à l'étape b) : b6) déposer un isolant thermique dans les parties gravées à l'étape a) et restées libres à l'étape b3), jusqu'au niveau supérieur de la première couche ; b7) déposer un isolant thermique dans les parties gravées à l'étape b4) et restées vides après l'étape b5), jusqu'au niveau supérieur de la première couche ; et b8) retirer les parties de la structure situées au-dessus du niveau des sommets des éléments de chauffage.

Selon un mode de réalisation, on laisse en place à l'étape c6) pour chaque élément de chauffage un ruban s'étendant dans le sens de l'épaisseur des espaceurs, ledit ruban comprenant l'élément de chauffage entre des portions des espaceurs, la largeur dudit ruban étant inférieure à 30 nm.

Selon un mode de réalisation, chaque isolant thermique est en oxyde de silicium ou en oxycarbure de silicium, et lesdits espaceurs et la troisième couche sont en nitrure de silicium ou en carbonitrure de silicium.

Selon un mode de réalisation, le procédé comprend, avant l'étape b), le dépôt d'une couche d'arrêt de gravure.

Un mode de réalisation prévoit une puce électronique comprenant : des points mémoire à matériau changement de phase ; un premier niveau de métal comportant des premières pistes d'interconnexion traversant une couche isolante ; et des éléments de chauffage des matériaux à changement de phase, situés contre les flancs de portions de ladite couche isolante.

Selon un mode de réalisation, les premières pistes d'interconnexion remplissent des tranchées traversant la couche isolante.

Selon un mode de réalisation, les premières pistes d'interconnexion sont reliées à des bornes de transistors par des premiers vias ; les matériaux à changement de phase sont situés sur les éléments de chauffage ; et les éléments de chauffage sont reliés aux transistors par des deuxièmes vias.

Selon un mode de réalisation : un deuxième niveau de métal comportant des deuxièmes pistes d'interconnexion est situé au-dessus du premier niveau de métal ; et les matériaux à changement de phase sont situés entre les premier et deuxième niveaux de métal et reliés aux deuxièmes pistes d'interconnexion par des troisièmes vias.

Selon un mode de réalisation, chaque élément de chauffage traverse une région thermiquement isolante, chaque élément de chauffage étant entouré d'une région de protection séparant l'élément de chauffage de la région thermiquement isolante, la région thermiquement isolante comprenant de l'oxyde de silicium ou de l'oxycarbure de silicium, et la région de protection étant en nitrure de silicium ou en carbonitrure de silicium.

La portée de l'invention est définie dans les revendications annexées. Toute référence comme "mode (s) de réalisation", "exemple (s)" ou "aspect (s) de l'invention" dans cette description n'entrant pas dans le cadre des revendications doit être interprétée comme un ou des exemples illustratifs pour comprendre l'invention.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'une puce à mémoire embarquée à matériau à changement de phase ;
les figures 2A à 2C sont des vues en coupe, partielles et schématiques, illustrant des étapes d'un mode de réalisation d'un procédé de fabrication d'une puce à mémoire embarquée à matériau à changement de phase ; et
les figures 3A à 3M illustrent schématiquement un exemple plus détaillé d'étapes de mise en oeuvre du procédé des figures 2A à 2C.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les transistors et leur procédé de fabrication, connus de l'homme du métier, ne sont pas décrits en détails.

Dans la description qui suit, lorsque l'on fait référence à des qualificatifs de position tels que les termes "dessus", "dessous", "supérieur", "inférieur", "horizontal", "vertical", etc., il est fait référence à l'orientation de l'élément concerné dans les vues en coupe, étant entendu que, dans la pratique, les dispositifs décrits peuvent être orientés différemment.

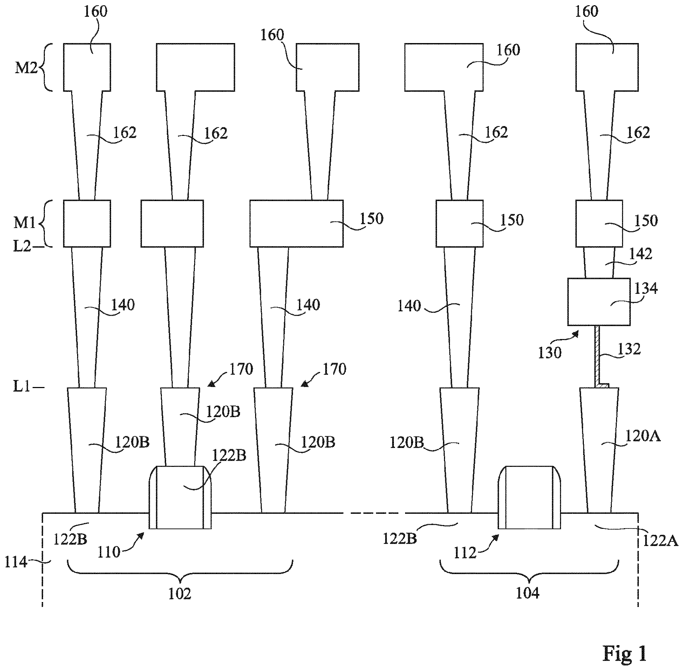

La figure 1 est une vue en coupe, partielle et schématique, d'une puce à mémoire non volatile embarquée à matériau à changement de phase.

La puce comprend une région 102 dans laquelle sont situés des circuits comportant des transistors 110, et une région 104 dans laquelle sont situés des points mémoire à matériau à changement de phase associés à des transistors 112. Un transistor 110 et un transistor 112 sont représentés chacun par une grille isolée flanquée d'espaceurs. La puce a été obtenue de la manière décrite ci-après.

On a d'abord formé les transistors 110 et 112 dans et sur un substrat 114. On a ensuite mis en oeuvre des étapes de dépôt sur la structure de couches électriquement isolantes (non représentées), et de formation d'éléments électriquement conducteurs dans ces couches d'isolant. Les éléments conducteurs formés sont successivement :
- des vias 120A et des vias 120B, les vias 120A s'étendant à partir de prises de contact 122A des drains des transistors 112, et les vias 120B s'étendant à partir de prises de contact 122B des drains, des sources et des grilles des transistors 110 et des sources des transistors 112; les vias 120A et 120B atteignent un même niveau L1 au-dessus du substrat 114 ;
- des points mémoire 130 comprenant chacun, sur un des vias 120A, un élément de chauffage 132 surmonté d'une région 134 de matériau à changement de phase ;
- des vias 140 situés sur les vias 120B, et des vias 142 situés chacun sur une des régions 134, les vias 140 et 142 s'étendant jusqu'à un même niveau L2 au-dessus du substrat 114 ;
- un premier niveau de métal M1 comprenant des premières pistes d'interconnexion 150 en contact avec les vias 140 et 142 ; et
- un deuxième niveau de métal M2 comprenant des deuxièmes pistes d'interconnexion 160 reliées aux pistes 150 par des vias 162.

Dans la puce ainsi obtenue, les prises de contact, ou bornes, 122B des transistors sont reliées aux pistes 150 du premier niveau de métallisation M1 par des empilements 170 d'un via 120B et d'un via 140. Un problème est que la résistance électrique de chaque empilement 170 est élevée, en particulier en raison de la hauteur élevée de l'empilement 170 et en raison de diverses difficultés, notamment d'alignement, pour réaliser le contact électrique entre le via 120B et le via 140. Il résulte de cette résistance électrique diverses difficultés de performance et de consommation électrique, en particulier des circuits de la région 102.

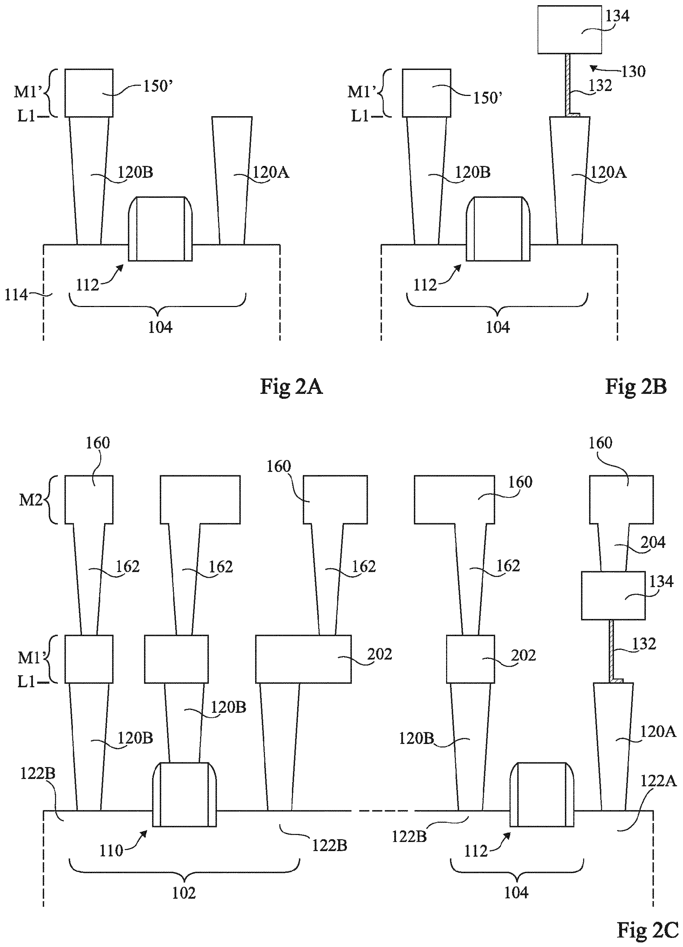

Les figures 2A à 2C sont des vues en coupe, partielles et schématiques, illustrant des étapes d'un mode de réalisation d'un procédé de fabrication d'une puce à mémoire à matériau à changement de phase embarquée. Seule une région 104 de mémoire à matériau à changement de phase est représentée, de manière partielle, en figures 2A et 2B. Comme en figure 1A, les couches isolantes recouvrant les transistors et le substrat ne sont pas représentées en figures 2A et 2B.

A l'étape de la figure 2A, on forme des éléments identiques ou similaires à ceux de la puce de la figure 1 situés sous le même niveau L1 que celui de la figure 1, disposés de manière identique ou similaire. Ces éléments sont notamment, dans la région 104, un transistor 112, et, à partir des prises de contact de drain 122A et de source 122B du transistor 112, des vias respectifs 120A et 120B s'étendant jusqu'au niveau L1.

On forme un premier niveau de métal M1' comprenant des premières pistes d'interconnexion 202 sur les vias 120B. On note qu'on ne forme pas de piste sur les vias 120A. Contrairement aux pistes 150 de la figure 1, les pistes 202 sont directement en contact avec les vias 120B.

A l'étape de la figure 2B, on forme des points mémoire 130 comprenant chacun, sur un des vias 120A, un élément de chauffage 132 surmonté d'une région 134 de matériau à changement de phase.

A l'étape de la figure 2C, on forme un deuxième niveau de métal M2, situé au-dessus du niveau des régions 134 et comprenant des deuxièmes pistes d'interconnexion 160. Les pistes 160 sont reliées aux pistes 150 par des vias 162 et aux régions 134 par des vias 204.

Dans la puce obtenue, chaque point mémoire a son matériau à changement de phase 134 situé entre les niveaux M1' et M2.

Selon un avantage, du fait que les régions 134 de matériau à changement de phase sont situées entre les niveaux M1' et M2, on a pu relier directement les pistes 202 du premier niveau de métal M1' aux prises de contact 122B des transistors par les vias 120B. La résistance électrique d'accès aux transistors est particulièrement réduite. En effet, contrairement aux empilements 170 de la puce de la figure 1, les vias 120B sont formés en une seule étape. De plus, les vias 120B ont une hauteur réduite par rapport aux empilements 170 de la puce de la figure 1. Il en résulte que les circuits de la région 102 ont une consommation électrique réduite. On note que cet avantage de résistance électrique réduite existe aussi pour la liaison directe par le via 120B entre les transistors 112 de la région 104 de points mémoire et les pistes 202, ce qui permet une consommation électrique réduite des points mémoire.

Selon un autre avantage, la liaison entre le matériau à changement de phase 134 et les pistes 160 est formée par un unique via 204, contrairement à la liaison entre le matériau à changement de phase 134 et les pistes 160 de la puce de la figure 1, formée par l'intermédiaire d'un via 142, d'une piste 150 et d'un via 162. On évite ainsi diverses difficultés de réalisation du via 142 de la figure 1, telles que des difficultés d'alignement.

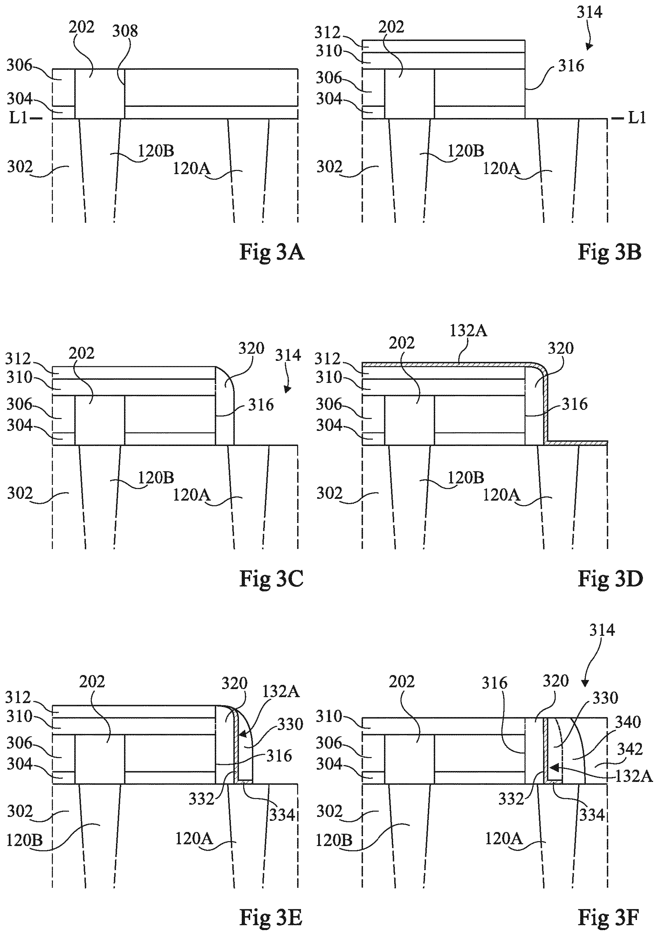

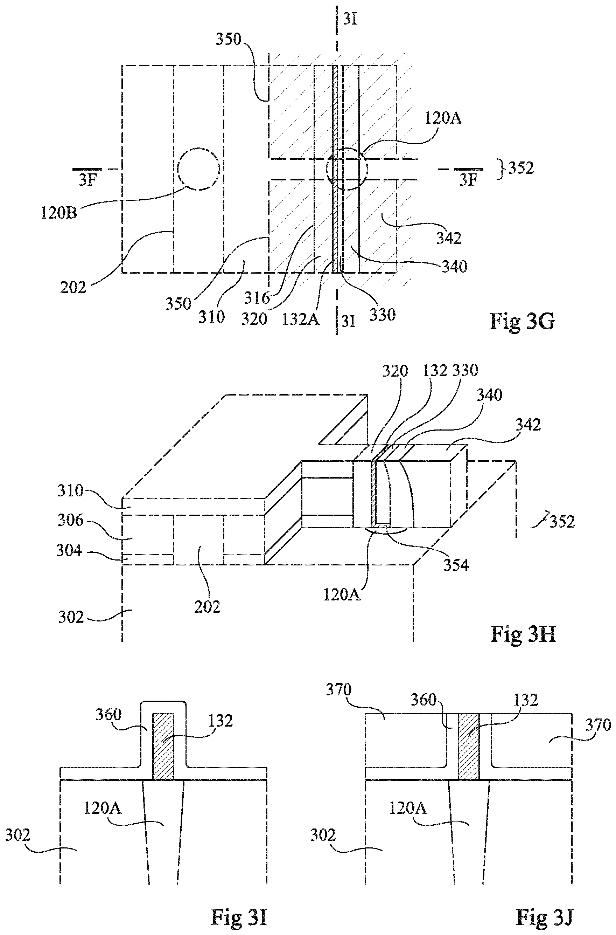

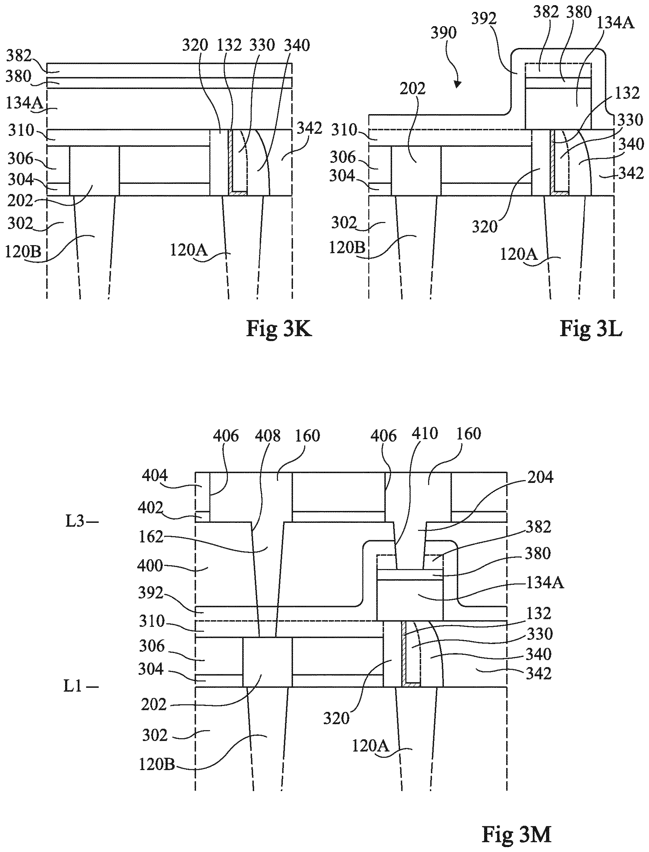

Les figures 3A à 3L illustrent schématiquement un exemple plus détaillé d'étapes de mise en oeuvre du procédé des figures 2A à 2C. Les figures 3A à 3F sont des vues partielles en coupe selon une première direction, la figure 3G est une vue partielle de dessus, la figure 3H est une vue partielle en perspective, les figures 3I et 3J sont des vues partielles en coupe selon une deuxième direction orthogonale à la première direction, et les figures 3K et 3L sont des vues partielles en coupe selon la première direction. Seule la région 104 de mémoire est représentée, de manière partielle.

La figure 3A illustre l'étape de formation du premier niveau de métal de la figure 2A. On part de la structure comprenant les éléments situés sous le niveau L1, en particulier les vias 120A et 120B, dont seules les parties supérieures sont représentées. Les vias 120A et 120B sont dans une couche d'isolant 302, par exemple en oxyde de silicium ou à base d'oxyde de silicium, et affleurent la surface de la couche d'isolant 302 au niveau L1. A titre d'exemple, les vias 120A et 120B sont en tungstène.

On recouvre la structure d'une couche 304 d'arrêt de gravure, par exemple en carbonitrure de silicium. On forme ensuite sur la structure une couche 306, de préférence thermiquement isolante et à faible constante diélectrique, par exemple en un oxyde de silicium, par exemple poreux. A titre d'exemple, la couche 304 a une épaisseur comprise entre 10 et 25 nm. La couche 306 a une épaisseur comprise par exemple entre 30 et 200 nm.

On grave ensuite des tranchées 308 traversant les couches 306 et 304 aux emplacements des futures premières pistes d'interconnexion 202, c'est-à-dire au-dessus des vias 120B. Les tranchées sont gravées jusqu'à la surface supérieure, ou sommet, des vias 120B.

Après cela, on remplit les tranchées 308 d'un matériau électriquement conducteur, par exemple du cuivre, jusqu'au niveau supérieur de la couche 306. Pour effectuer ce remplissage, on peut par exemple recouvrir la structure d'une couche du matériau conducteur remplissant les tranchées 308, puis retirer par polissage mécanochimique l'ensemble des éléments situés au-dessus du niveau supérieur de la couche 306.

A l'étape de la figure 3B, on recouvre la structure d'une couche 310, par exemple en nitrure de silicium, destinée à protéger les pistes 202 au cours de la réalisation du point mémoire. On forme ensuite une couche d'oxyde de silicium 312 sur la structure. A titre d'exemple, la couche de protection 310 a une épaisseur comprise entre 10 et 40 nm.

Après cela, on grave toute l'épaisseur des couches 312, 310, 306 et 304 dans des parties 314, de manière à dégager au moins en partie le sommet de chacun des vias 120A. Les portions restantes des couches gravées présentent des flancs 316. Pour chaque via 120A, un flanc 316 est positionné par rapport au via 120A d'une manière choisie décrite ci-après en relation avec l'étape de la figure 3C.

A l'étape de la figure 3C, on forme un espaceur 320 contre chaque flanc 316, c'est-à-dire que l'on recouvre la structure d'une couche du matériau de l'espaceur 320, par exemple un nitrure de silicium, et que l'on retire les portions horizontales de cette couche par gravure anisotrope. La position par rapport au via 120A du flanc 316 obtenu à l'étape de la figure 3B, et l'épaisseur de l'espaceur 320, sont choisies de sorte que l'espaceur 320 recouvre partiellement le sommet du via 120A en laissant le via 120A partiellement exposé, c'est-à-dire de sorte que le flanc exposé de l'espaceur se trouve à l'aplomb du via 120A. A titre d'exemple, les espaceurs 320 ont une épaisseur comprise entre 5 et 30 nm.

A l'étape de la figure 3D, on recouvre la structure de manière conforme d'une couche 132A destinée à former les futurs éléments de chauffage. La couche 132A est par exemple en nitrure de silicium et de titane TiSiN. La couche 132A recouvre un flanc de chaque espaceur 320 et une partie de chaque via 120A. A titre d'exemple, la couche 132A a une épaisseur comprise entre 2 et 10 nm.

A l'étape de la figure 3E, on forme un espaceur 330, par exemple en nitrure de silicium, contre la portion de la couche 132A recouvrant chaque espaceur 320. On retire par gravure les portions restées exposées de la couche 132A. A cette étape, seules subsistent de la couche 132A des portions verticales 332 entre les espaceurs 320 et 330, et des portions horizontales 334 sous les espaceurs 330. A titre d'exemple, les espaceurs 330 ont une épaisseur comprise entre 5 et 30 nm.

A l'étape de la figure 3F, on forme un espaceur 340, par exemple en nitrure de silicium, contre chaque espaceur 330. Les espaceurs 340 recouvrent les flancs des portions horizontales 334 des restes de la couche 132A. A titre d'exemple, les espaceurs 340 ont une épaisseur comprise entre 5 et 30 nm.

Après cela, on recouvre la structure d'une couche 342, de préférence thermiquement isolante, par exemple en oxyde de silicium, atteignant, dans les parties 314 gravées à l'étape de la figure 3B et restées libres, le niveau de la surface supérieure de la couche 310. On retire ensuite par polissage mécanochimique l'ensemble des éléments situés au-dessus du niveau supérieur de la couche 310.

La figure 3G est une vue de dessus de la structure de la figure 3F, dans l'exemple d'un flanc 316 rectiligne. On grave les divers éléments recouvrant les vias 120A, 120B et l'isolant 302, jusqu'au niveau supérieur des vias 120A et 120B, dans des régions 350 représentées en figure 3G par des hachures délimitées par des pointillés. Les régions 350 sont prévues pour que la gravure laisse en place, pour chaque via 120A, les éléments situés en vue de dessus, par exemple dans une bande 352 passant sur le via 120A et s'étendant dans le sens de l'épaisseur des espaceurs, c'est-à-dire orthogonalement à la direction du flanc 316. Les régions 350 sont prévues pour que la gravure laisse en outre en place les parties des couches 304, 306 et de la couche de protection 310 encadrant et recouvrant les pistes 202.

La figure 3H représente la structure obtenue après gravure des régions 350. La gravure a individualisé pour chaque via 120A une portion verticale de la couche 132A située sur le via 120A (dont seule une partie de la face supérieure est visible). Cette portion forme l'élément de chauffage 132. L'élément de chauffage se prolonge en partie basse par une partie horizontale 334. On a laissé en place des portions des espaceurs 320, 330 prenant l'élément de chauffage en sandwich et recouvrant la partie horizontale 334, et une portion d'espaceur 340 contre le flanc de la partie horizontale 334.

De préférence, la largeur de l'élément de chauffage, correspondant à la largeur de la bande 352, est réduite, par exemple inférieure à 30 nm. A titre d'exemple, l'élément de chauffage est intégralement situé sur le via 120A. A titre d'exemple, le via 120A a un diamètre compris entre 30 et 60 nm.

A l'étape de la figure 3I, on recouvre de manière conforme l'ensemble de la structure d'une couche de protection 360, par exemple en nitrure de silicium.

A l'étape de la figure 3J, on dépose sur la structure une couche 370 d'un matériau de préférence thermiquement isolant, par exemple un oxyde de silicium, atteignant, dans les parties des régions 150 restées libres, le niveau supérieur des éléments de chauffage 132. On retire ensuite par polissage mécanochimique tous les éléments situés au-dessus du niveau supérieur des éléments de chauffage 132.

Chaque élément de chauffage 132 ainsi obtenu est entièrement entouré par les portions des espaceurs 320, 330, 340 et de la couche 360.

A l'étape de la figure 3K, on recouvre la structure : d'une couche 134A du matériau à changement de phase, par exemple un chalcogénure ; d'une couche électriquement conductrice 380, par exemple en nitrure de titane ; puis d'une couche de masquage 382, par exemple en nitrure de silicium.

A l'étape de la figure 3L, on grave les couches 382, 380 et 134A dans des régions 390, de manière à laisser en place sur chaque élément de chauffage une région 134A du matériau à changement de phase surmontée d'une portion de la couche 380 formant une prise de contact. On a ainsi formé les points mémoire.

Après cela, on recouvre la structure d'une couche de protection 392, par exemple un nitrure de silicium.

L'étape de la figure 3M correspond à celle de la figure 2C, de formation des vias 162 et 204 et des deuxièmes pistes d'interconnexion 160. On recouvre la structure d'un isolant 400, par exemple à base d'oxyde de silicium, jusqu'à un niveau L3.

On recouvre ensuite la structure successivement d'une couche 402 d'arrêt de gravure par exemple en carbonitrure de silicium et d'une couche 404 à faible constante diélectrique, par exemple en oxyde de silicium, par exemple poreux.

On grave des tranchées 406 traversant les couches 404 et 402 sur toute leur épaisseur aux emplacements des futures deuxièmes pistes d'interconnexion 160.

On grave les emplacements des futurs vias 162 et 204 à partir du fond des tranchées 406, jusqu'aux pistes 202 pour les vias 162 (emplacement 408), et jusqu'à la prise de contact 380 (emplacement 410) pour les vias 204.

Après cela, on remplit les tranchées 406 et les emplacements 408 et 410 d'un matériau conducteur, par exemple du cuivre, jusqu'au niveau supérieur de la couche 404.

Outre les avantages déjà décrits, un avantage de la puce obtenue en mettant en oeuvre l'exemple de procédé des figures 3A à 3M provient du fait que chaque élément de chauffage 132 est encadré latéralement de portions des couches 306 et 342, ainsi que de portions de la couche 370 (non visibles en figure 3M). Les portions des couches 306 et 342 encadrent l'élément de chauffage 132 selon une direction orthogonale à celle du flanc 316 (selon le plan de la figure 3M), et les portions de la couche 370 encadrent l'élément de chauffage 132 selon une direction parallèle à celle du flanc 316. Les portions des couches 306, 342 et 370 forment ainsi une région thermiquement isolante, par exemple en oxyde de silicium, traversée par l'élément de chauffage 132. L'oxyde de silicium a une conductivité thermique faible, inférieure à une valeur de l'ordre de 1,5 W/(m·K), soit par exemple plus de 10 à 40 fois plus faible que celle du nitrure de silicium (qui peut être par exemple de l'ordre de 17 W/(m·K)). Ceci permet d'éviter que, lorsque l'élément de chauffage s'échauffe au cours par exemple de la programmation du point mémoire, les régions environnant l'élément de chauffage s'échauffent elles aussi. Un tel échauffement risquerait de provoquer, par exemple, l'effacement de points mémoires voisins. En outre, on évite qu'une partie de la chaleur produite dans l'élément de chauffage soit perdue dans les régions environnantes. Des quantités réduites de chaleur produite suffisent alors pour échauffer l'élément de chauffage, ce qui correspond à une consommation électrique réduite pour programmer et effacer le point mémoire.

On note que chaque élément de chauffage est séparé des matériaux des couches 306, 342 et 370 par des portions des espaceurs 320, 330 et 340 et de la couche 360 par exemple en nitrure de silicium. Les portions des espaceurs 320, 330 et 340 et de la couche 360 forment ainsi une région de protection de l'élément de chauffage. Ceci permet que chaque élément de chauffage soit uniquement en contact avec le nitrure de silicium. On évite ainsi un contact entre l'élément de chauffage et un matériau tel que, par exemple, l'oxyde de silicium des couches 306, 342 et 370. Un tel contact serait susceptible d'altérer le matériau de l'élément de chauffage, par exemple si l'élément de chauffage est en nitrure de silicium et de titane.

Selon un autre avantage, la prévision d'un élément de chauffage de largeur réduite permet de réduire le volume de matériau à changement de phase à chauffer pour la programmation ou l'effacement. Des quantités réduites de chaleur produite dans l'élément de chauffage suffisent à programmer et effacer le point mémoire, ce qui permet une consommation électrique réduite.

Des modes de réalisation particuliers ont été décrits. Diverses variantes et modifications apparaîtront à l'homme de l'art. Bien que, dans les étapes des figures 3A à 3M, des régions thermiquement isolantes (portions des couches 306, 342 et 370) traversées par des éléments de chauffage soient en oxyde de silicium, on pourra utiliser pour ces régions tout matériau thermiquement isolant adapté, c'est-à-dire ayant une conductivité thermique inférieure par exemple à 2 W/(m·K). A titre d'exemple, on pourra remplacer l'oxyde de silicium de tout ou partie de ces régions par de l'oxycarbure de silicium, par exemple poreux. On pourra alors omettre les espaceurs 320 et 340 dans le cas où on utilise pour ces régions un matériau pouvant être en contact avec l'élément de chauffage sans risque de l'endommager.

En outre, bien que les espaceurs 320, 330 et 340, et la couche 370 décrits ci-dessus soient en nitrure de silicium, on pourra remplacer le nitrure de silicium de tout ou partie de ces régions par tout autre matériau adapté à protéger l'élément de chauffage, tel que du carbonitrure de silicium.

Bien qu'un exemple particulier d'étapes de mise en oeuvre du procédé des figures 2A à 2C ait été décrit en relation avec les figures 3A à 3M, on peut prévoir toutes autres étapes adaptées à mettre en oeuvre le procédé des figures 2A à 2C. En particulier, on peut remplacer les étapes de formation des éléments de chauffage et de formation de régions de matériau à changement de phase, décrites en relation avec les figures 3A à 3M, par tout procédé de formation d'éléments de chauffage surmontés de régions de matériau à changement de phase.

Bien que les transistors 110 et 112 décrits ci-dessus soient représentés par des grilles flanquées d'espaceurs, les transistors 110 et/ou 112 peuvent être des transistors bipolaires, les grilles, sources et drains décrits ci-dessus correspondant alors respectivement aux bases, collecteurs et émetteurs des transistors.

## Revendications

1. Procédé de fabrication d'une puce électronique comportant des points mémoire (130) à matériau à changement de phase (134), comprenant :
a) former un premier niveau de métal comprenant des premières pistes d'interconnexion (202) traversant une première couche (306) isolante ;
b) pour chaque point mémoire (130), former un élément de chauffage (132) du matériau à changement de phase contre des flancs de portions de la première couche ; et
avant l'étape b), la formation de premiers espaceurs (320) contre lesdits flancs en formant une couche en un matériau des premiers espaceurs et en retirant ensuite par gravure anisotrope les portions horizontales de la couche en matériau des premiers espaceurs, la première couche étant en un isolant thermique.

2. Procédé selon la revendication 1, comprenant :
avant l'étape a), former des transistors (110, 113) et des premiers (120B) et deuxièmes (120A) vias s'étendant depuis des bornes (122A, 122B) des transistors et atteignant une même hauteur, les premières pistes formées à l'étape a) étant en contact avec les premiers vias, et les éléments de chauffage formés à l'étape b) étant sur les deuxièmes vias ; et
c) former le matériau à changement de phase (134) de chaque point mémoire sur l'élément de chauffage (132).

3. Procédé selon la revendication 1 ou 2, comprenant :
former un deuxième niveau de métal comprenant des deuxièmes pistes d'interconnexion et situé au-dessus des matériaux à changement de phase ; et
former des troisièmes vias (204) s'étendant des matériaux à changement de phase jusqu'aux deuxièmes pistes d'interconnexion.

4. Procédé selon l'une quelconque des revendications 1 à 3, comprenant, entre les étapes a) et b), le dépôt d'une couche de protection (310), de préférence en nitrure de silicium, sur les premières pistes d'interconnexion (202).

5. Procédé selon l'une quelconque des revendications 1 à 4, comprenant à l'étape a) : graver des tranchées traversant la première couche (306) ; et remplir les tranchées par un matériau électriquement conducteur jusqu'à un niveau supérieur de la première couche.

6. Procédé selon la revendication 2, comprenant, à l'étape a), graver des portions de la première couche jusqu'au niveau des sommets des deuxièmes vias, lesdits flancs étant les flancs (316) des portions restantes de la première couche, en faisant en sorte que le sommet de chaque deuxième via (120A) soit partiellement recouvert d'un des premiers espaceurs et partiellement exposé ; et à l'étape b) :
b1) former une deuxième couche (132A) conforme en le matériau du futur élément de chauffage (132) ;
b2) former un deuxième espaceur (330) recouvrant la portion de la deuxième couche (132A) située contre chaque premier espaceur (320), puis retirer les parties exposées de la deuxième couche ;
b3) former un troisième espaceur (340) contre chaque deuxième espaceur (330) ;
b4) graver partiellement la structure jusqu'au niveau des sommets de deuxièmes vias (120A) de manière à individualiser les éléments de chauffage (132) constitués chacun d'une portion de la deuxième couche (132A) ; et
b5) recouvrir la structure d'une troisième couche (360) de protection.

7. Procédé selon la revendication 6, comprenant à l'étape b) :
b6) déposer un isolant thermique (342) dans les parties gravées à l'étape a) et restées libres à l'étape b3), jusqu'au niveau supérieur de la première couche (306) ;
b7) déposer un isolant thermique (370) dans les parties gravées à l'étape b4) et restées vides après l'étape b5), jusqu'au niveau supérieur de la première couche (306) ; et
b8) retirer les parties de la structure situées au-dessus du niveau des sommets des éléments de chauffage (132).

8. Procédé selon la revendication 6 ou 7, dans lequel on laisse en place à l'étape b4) pour chaque élément de chauffage un ruban s'étendant dans le sens de l'épaisseur des espaceurs, ledit ruban comprenant l'élément de chauffage entre des portions des espaceurs, la largeur dudit ruban étant inférieure à 30 nm.

9. Procédé selon l'une quelconque des revendications 6 à 8, dans lequel chaque isolant thermique (306, 342, 370) est un oxyde de silicium ou en oxycarbure de silicium, et lesdits espaceurs (320, 330, 340) et la troisième couche sont en nitrure de silicium ou en carbonitrure de silicium.

10. Procédé selon l'une quelconque des revendications 1 à 9, comprenant, avant l'étape b), le dépôt d'une couche d'arrêt de gravure (304).

11. Puce électronique obtenue par un procédé selon l'une quelconque des revendications 1 à 10, comprenant :
les points mémoire (130) à matériau à changement de phase (134) ;
le premier niveau de métal comportant les premières pistes d'interconnexion (202) traversant la couche isolante (306) ; et
les éléments de chauffage des matériaux à changement de phase, situés contre les flancs des portions de ladite couche isolante.

12. Puce électronique selon la revendication 11, dans laquelle les premières pistes d'interconnexion (202) remplissent des tranchées traversant la couche isolante (306).

13. Puce électronique selon la revendication 11 ou 12, dans laquelle :
les premières pistes d'interconnexion (202) sont reliées à des bornes de transistors par des premiers vias ;
les matériaux à changement de phase sont situés sur les éléments de chauffage ; et
les éléments de chauffage sont reliés aux transistors par des deuxièmes vias (120B).

14. Puce électronique selon l'une quelconque des revendications 11 à 13, dans laquelle :
un deuxième niveau de métal comportant des deuxièmes pistes d'interconnexion (160) est situé au-dessus du premier niveau de métal ; et
les matériaux à changement de phase sont situés entre les premier et deuxième niveaux de métal et reliés aux deuxièmes pistes d'interconnexion par des troisièmes vias (204).

15. Puce électronique selon l'une quelconque des revendications 11 à 14, dans laquelle chaque élément de chauffage (132) traverse une région thermiquement isolante (306, 342, 370), chaque élément de chauffage (132) étant entouré d'une région de protection (320, 330, 340, 360) séparant l'élément de chauffage de la région thermiquement isolante (306, 342, 370), la région thermiquement isolante (306, 342, 370) comprenant de l'oxyde de silicium ou de l'oxycarbure de silicium, et la région de protection (320, 330, 340, 360) étant en nitrure de silicium ou en carbonitrure de silicium.

## Patentansprüche

1. Verfahren zur Herstellung eines Elektronikchips mit Speicherzellen (130), die ein Phasenänderungsmaterial (134) aufweisen, wobei das Verfahren Folgendes aufweist:
a) Ausbilden einer ersten Metallebene mit ersten Verbindungsleiterbahnen (202), die eine erste Isolierschicht (306) überqueren;
b) für jede Speicherzelle (130), Ausbilden eines Elements (132) zum Erwärmen des Phasenänderungsmaterials an Seiten von Abschnitten der ersten Schicht; und
vor Schritt b), Ausbilden von ersten Abstandshaltern (320) an den Seiten durch Ausbilden einer Schicht aus einem Material der ersten Abstandshalter und anschließendes Entfernen der horizontalen Abschnitte der Schicht aus dem Material der ersten Abstandshalter durch anisotropes Ätzen, wobei die erste Schicht aus einem thermischen Isolator besteht.

2. Verfahren nach Anspruch 1, das Folgendes aufweist:
vor Schritt a) Ausbilden von Transistoren (110, 113) und ersten (120B) und zweiten (120A) Durchkontaktierungen, die sich von Anschlüssen (122A, 122B) der Transistoren aus erstrecken und eine gleiche Höhe erreichen, wobei die in Schritt a) ausgebildeten ersten Leiterbahnen in Kontakt mit den ersten Durchkontaktierungen stehen und die in Schritt b) ausgebildeten Heizelemente an den zweiten Durchkontaktierungen liegen; und
c) Ausbilden des Phasenänderungsmaterials (134) jeder Speicherzelle an dem Heizelement (132).

3. Verfahren nach Anspruch 1 oder 2, das Folgendes aufweist:
Ausbilden einer zweiten Metallebene, die zweite Verbindungsleiterbahnen aufweist und sich über den Phasenänderungsmaterialien befindet; und
Ausbilden dritter Durchkontaktierungen (204), die sich von den Phasenänderungsmaterialien zu den zweiten Verbindungsleiterbahnen erstrecken.

4. Verfahren nach einem der Ansprüche 1 bis 3, aufweisend zwischen den Schritten a) und b) das Abscheiden einer Schutzschicht (310), vorzugsweise aus Siliziumnitrid, an den ersten Verbindungsleiterbahnen (202).

5. Verfahren nach einem der Ansprüche 1 bis 4, aufweisend im Schritt a) das Ätzen von Gräben, die die erste Schicht (306) durchqueren; und das Auffüllen der Gräben mit einem elektrisch leitenden Material bis zu einem oberen Niveau der ersten Schicht.

6. Verfahren nach Anspruch 2, aufweisend
im Schritt a) das Ätzen von Abschnitten der ersten Schicht bis auf das Niveau der Oberseiten der zweiten Durchkontaktierungen, wobei die Seiten die Seiten (316) der verbleibenden Abschnitte der ersten Schicht sind, während sichergestellt wird, dass die Oberseite jeder zweiten Durchkontaktierung (120A) teilweise von einem der ersten Abstandshalter abgedeckt ist und teilweise freiliegt; und im Schritt b):
b1) Ausbilden einer zweiten konformen Schicht (132A) aus dem Material des zukünftigen Heizelements (132);
b2) Ausbilden eines zweiten Abstandshalters (330), der den Abschnitt der zweiten Schicht (132A) abdeckt, der an jedem ersten Abstandshalter (320) angeordnet ist, und anschließendes Entfernen der freiliegenden Abschnitte der zweiten Schicht;
b3) Ausbilden eines dritten Abstandshalters (340) an jedem zweiten Abstandshalter (330);
b4) teilweises Ätzen der Struktur bis auf das Niveau der Oberseiten der zweiten Durchkontaktierungen (120A), um die Heizelemente (132) zu individualisieren, die jeweils aus einem Teil der zweiten Schicht (132A) ausgebildet sind; und
b5) Abdecken der Struktur mit einer dritten Schutzschicht (360).

7. Verfahren nach Anspruch 6, aufweisend im Schritt b):
b6) Abscheiden eines thermischen Isolators (342) in den in Schritt a) geätzten Abschnitten, die nach Schritt b3) frei geblieben sind, bis zum oberen Niveau der ersten Schicht (306);
b7) Ablagern eines thermischen Isolators (370) in den in Schritt b4) geätzten Abschnitten, die nach Schritt b5) frei geblieben sind, bis zum oberen Niveau der ersten Schicht (306); und
b8) Entfernen der Abschnitte der Struktur, die sich oberhalb der Oberseiten der Heizelemente (132) befinden.

8. Verfahren nach Anspruch 6 oder 7, wobei im Schritt b4) für jedes Heizelement ein sich in Breitenrichtung der Abstandshalter erstreckender Streifen belassen wird, wobei der Streifen das Heizelement zwischen Abschnitten der Abstandshalter aufweist und die Breite des Streifens kleiner als 30 nm ist.

9. Verfahren nach einem der Ansprüche 6 bis 8, wobei jeder thermische Isolator (306, 342, 370) ein Siliziumoxid ist oder aus Siliziumoxycarbid hergestellt ist, und die Abstandshalter (320, 330, 340) und die dritte Schicht aus Siliziumnitrid oder aus Siliziumcarbonitrid hergestellt sind.

10. Verfahren nach einem der Ansprüche 1 bis 9, das vor Schritt b) das Abscheiden einer Ätzstoppschicht (304) aufweist.

11. Elektronikchip, der durch ein Verfahren nach einem der Ansprüche 1 bis 10 hergestellt ist und der Folgendes aufweist:
die Speicherzellen (130), die Phasenänderungsmaterial (134) aufweisen;
die erste Metallebene mit den ersten Verbindungsleiterbahnen (202), die die Isolierschicht (306) überqueren; und
die Elemente zum Erwärmen der Phasenänderungsmaterialien, die an den Seiten der Abschnitte der Isolierschicht angeordnet sind.

12. Elektronikchip nach Anspruch 11, wobei die ersten Verbindungsleiterbahnen (202) die Isolierschicht (306) überquerende Gräben füllen.

13. Elektronikchip nach Anspruch 11 oder 12, wobei:
die ersten Verbindungsleiterbahnen (202) über erste Durchkontaktierungen mit Anschlüssen von Transistoren gekoppelt sind;
die Phasenänderungsmaterialen an den Heizelementen angeordnet sind; und
die Heizelemente über zweite Durchkontaktierungen (120B) mit den Transistoren gekoppelt sind.

14. Elektronikchip nach einem der Ansprüche 11 bis 13, wobei:
eine zweite Metallebene mit zweiten Verbindungsleiterbahnen (160) über der ersten Metallebene angeordnet ist; und
die Phasenänderungsmaterialien zwischen der ersten und der zweiten Metallebene angeordnet sind und mit den zweiten Verbindungsleiterbahnen über dritte Durchkontaktierungen (204) gekoppelt sind.

15. Elektronikchip nach einem der Ansprüche 11 bis 14, bei dem jedes Heizelement (132) einen thermisch isolierenden Bereich (306, 342, 370) überquert, wobei jedes Heizelement (132) von einem Schutzbereich (320, 330, 340, 360) umgeben ist, der das Heizelement von dem thermisch isolierenden Bereich (306, 342, 370) trennt, wobei der thermisch isolierenden Bereich (306, 342, 370) Siliziumoxid oder Siliziumoxycarbid aufweist und der Schutzbereich (320, 330, 340, 360) aus Siliziumnitrid oder aus Siliziumcarbonitrid hergestellt ist.

## Claims

1. Method of manufacturing an electronic chip comprising memory cells (130) comprising phase-change material (134), comprising:
a) forming a first metal level comprising first interconnection tracks (202) crossing a first insulating layer (306);
b) for each memory cell (130), forming an element (132) for heating the phase-change material against sides of portions of the first layer; and
before step b), forming first spacers (320) against said sides by forming a layer of a material of the first spacers and by then removing by anisotropic etching the horizontal portions of the layer of the material of the first spacers, the first layer being made of a thermal insulator.

2. Method according to claim 1, comprising:
before step a), forming transistors (110, 113) and first (120B) and second (120A) vias extending from terminals (122A, 122B) of the transistors and reaching a same height, the first tracks formed at step a) being in contact with the first vias, and the heating elements formed at step b) being on the second vias; and
c) forming the phase-change material (134) of each memory cell on the heating element (132).

3. Method according to claim 1 or 2, comprising:
forming a second metal level comprising second interconnection tracks and located above the phase-change materials; and
forming third vias (204) extending from the phase-change materials to the second interconnection tracks.

4. Method according to any of claim 1 to 3, comprising, between steps a) and b), depositing a protection layer (310), preferably made of silicon nitride, on the first interconnection tracks (202).

5. Method according to any of claims 1 to 4, comprising at step a) : etching trenches crossing the first layer (306); and filling the trenches with an electrically-conductive material up to an upper level of the first layer.

6. Method according to claim 2, comprising, at step a), etching portions of the first layer down to the level of the tops of the second vias, said sides being the sides (316) of the remaining portions of the first layer, while ascertaining that the top of each second via (120A) is partially covered with one of the first spacers and partially exposed; and at step b):
b1) forming a second conformal layer (132A) made of the material of the future heating element (132);
b2) forming a second spacer (330) covering the portion of the second layer (132A) located against each first spacer (320), and then removing the exposed portions of the second layer;
b3) forming a third spacer (340) against each second spacer (330);
b4) partially etching the structure down to the level of the tops of second vias (120A) to individualize the heating elements (132) each formed of a portion of the second layer (132A); and
b5) covering the structure with a third protection layer (360).

7. Method according to claim 6, comprising, at step b) :
b6) depositing a thermal insulator (342) in the portions etched at step a) and which have remained free at step b3), up to the upper level of the first layer (306);
b7) depositing a thermal insulator (370) in the portions etched at step b4) and which have remained empty after step b5), up to the upper level of the first layer (306) ; and
b8) removing the portions of the structure located above the tops of the heating elements (132).

8. Method according to claim 6 or 7, wherein, at step b4), for each heating element, a strip extending in the widthwise direction of the spacers, is left in place, said strip comprising the heating element between portions of the spacers, the width of said strip being smaller than 30 nm.

9. Method according to any of claims 6 to 8, wherein each thermal insulator (306, 342, 370) is a silicon oxide or made of silicon oxycarbide, and said spacers (320, 330, 340) and the third layer are made of silicon nitride or of silicon carbonitride.

10. Method according to any of claims 1 to 9, comprising, before step b), depositing an etch stop layer (304) .

11. Electronic chip obtained by a method according to any of claims 1 to 10, comprising:
the memory cells (130) comprising phase-change material (134);
the first metal level comprising the first interconnection tracks (202) crossing the insulating layer (306) ; and
the elements for heating the phase-change materials, located against the sides of the portions of said insulating layer.

12. Electric chip according to claim 11, wherein the first interconnection tracks (202) fill trenches crossing the insulating layer (306).

13. Electronic chip according to claim 11 or 12, wherein:
the first interconnection tracks (202) are coupled to terminals of transistors by first vias;
the phase-change materials are located on the heating elements; and
the heating elements are coupled to the transistors by second vias (120B).

14. Electronic chip according to any of claims 11 to 13, wherein:
a second metal level comprising second interconnection tracks (160) is located above the first metal level; and
the phase-change materials are located between the first and second metal levels and coupled to the second interconnection tracks by third vias (204).

15. Electronic chip according to any of claims 11 to 14, wherein each heating element (132) crosses a thermally-insulating region (306, 342, 370), each heating element (132) being surrounded with a protection region (320, 330, 340, 360) separating the heating element from the thermally-insulating region (306, 342, 370), the thermally-insulating region (306, 342, 370) comprising silicon oxide or silicon oxycarbide, and the protection region (320, 330, 340, 360) being made of silicon nitride or of silicon carbonitride.
